# EUROPEAN PATENT APPLICATION

(11) **EP 4 266 838 A1**
(43) Date of publication of application: **25.10.2023**
(21) Application number: 22465531.6
(22) Date of filing: 21.04.2022
(51) Int. Cl.: H05K 3/24

(54) **METHOD FOR APPLYING AN ELECTROCHEMICAL PROCESS**

(71) Applicant: Continental Automotive Technologies GmbH, 30165 Hannover (DE)
(72) Inventor: Sipilä, Pekka, 81737 München (DE); Nitzschke, Michael, 81737 München (DE); Helfrich, Ludwig, 81737 München (DE); Bebendorf, Markus, 81737 München (DE); Moisa, Cosmin, 81737 München (DE)
(74) Representative: Continental Corporation

(57) **Abstract**

The invention relates to a method for applying an electrochemical process on a plurality of conductors on a circuit board, wherein the circuit board is fabricated such that at least some of the conductors are electrically connected to each other by temporary electric lines, then the electrochemical process is applied, and then the temporary electric lines are removed. This can enable setting all the conductors to a specific electric potential.

## Description

The invention relates to a method for applying an electrochemical process on a plurality of conductors on a circuit board.

When applying electrochemical processes for complete circuit boards, the process may be applied to a plurality of conductors which have no electric connection to each other. Especially, such conductors may be used for contacting passive or active electronic components like resistors, capacitors, or processors with each other and with other components.

It is an object of the invention to provide for a method for applying an electrochemical process that is better or alternative compared to known solutions. This is achieved by a method according to claim 1. Preferred embodiments can, for example, be derived from the respective dependent claims. The content of the claims is made a content of the description by explicit reference.

The invention relates to a method for applying an electrochemical process on a plurality of conductors on a circuit board. The method comprises the following steps:
- fabricating the circuit board such that at least some of the conductors are electrically connected to each other by temporary electric lines, then
- applying the electrochemical process, then
- removing the temporary electric lines.

With such a method, the conductors on a circuit board can be connected by respective temporary electric lines, which are only present as long as they are needed, especially in order to set all conductors to a specific electric potential. The temporary electric lines will not be present in the final version of the circuit board, but only during manufacturing, especially during applying the electrochemical process. The temporary electric lines can be designed already when designing the circuit board, and can be securely removed when they are no longer needed.

An electrochemical process can, for example, be a process which grows small needles on the conductors. This can especially be used in order to ease connection to other components, for example before, or instead of, soldering connections on the conductors. The conductors can especially be conducting wires and/or conducting pads, or arrangements of such entities. In principle, a conductor can be any conducting entity being placed on a circuit board. The circuit board is typically a planar object; however, it can also have a different shape.

An exemplary electrochemical process may be used to grow a lawn of metallic nanowires or whisker. The process may be initiated with a sponge soaked with an electrolyte. The sponge has a special nanostructure that defines the characteristics of the lawn of nanowires, which emerges through electrochemical reaction when this sponge is brought in contact with a conductive surface, e.g., electric pad on a printed circuit board, and an electric potential difference is applied between this conductive surface and the electrolyte-soaked sponge.

The removing may especially comprise applying a laser beam, an ion beam and/or an electron beam on the temporary electric lines. Such beams have been proven suitable for removal of the electric lines. However, also other means can be used.

The removing may comprise melting the temporary electric lines by applying a current to the respective temporary electric lines. The current may especially be of a magnitude that the temporary electric lines melt due to increased temperature caused by the current, whereas the conductors, which should be present in the final version of the circuit board, do not melt. The melted material can be removed, for example, by vacuum suction and/or by sucking into a porous structure.

The mentioned mechanisms for removing the temporary electric lines may also be combined.

The conductors electrically connected to each other may be grounded, or set to a specific electric potential, before and/or during applying the electrochemical process. This can especially be done by grounding, or connecting to a specific voltage source, one conductor, which is connected to the other conductors by the temporary electric lines. Thus, a specific potential can be applied, which can be beneficial for applying the electrochemical process.

The temporary electric lines may especially have a smaller width compared to the conductors. This can facilitate removal of the temporary electric lines, as they may, for example, be melted with a current that will not melt the conductors.

The temporary electric lines may be made from the same material as the conductors. This can facilitate manufacturing. However, also other materials can be used.

The temporary electric lines may be fabricated in the same process and/or using the same steps as the conductors. This can also facilitate manufacturing of the conductors and the temporary electric lines. However, also other processes and/or steps may be used.

The circuit board may be fabricated such that all conductors are electrically connected to each other by temporary electric lines. This can facilitate grounding or setting all conductors to the same electric potential, as they all are temporarily connected, until the temporary electric lines are removed.

Especially, the conductors may be electrically separate on the circuit board. Thus, they can be temporarily electrically connected using the temporary electric lines. Especially, the conductors may be arranged on the circuit board in pads and/or lines. Such pads or lines form typical components of a conductor structure on a circuit board.

The method may further comprise, after removing the temporary electric lines, the following step:
- depositing a passivation layer and/or protective layer on the circuit board, covering the conductors.

This means that the passivation layer and/or protective layer may cover the conductors after the electrochemical process has been applied and the temporary electric lines have been removed.

Especially, it can be noted that in a layout process, a designer can design thin pieces of conductors to short-circuit all the contact pads of the circuit, and only a single point of electric contact may be needed to ensure the connection to the voltage source for the electrochemical process. The pieces may especially be thin with respect to their cross-sectional area, not just in only one direction, but also in two directions (especially vertical and/or horizontal with respect to a horizontally oriented circuit board). This can be done simply by a metal pin, or a crimp. These shorts in the circuit layout may especially be removed before operation to avoid any malfunctions. The removal can be done in different ways. If all the shorts are on the surface, a strong laser or ion/electron beam can be applied in order to burn the electric shorts away. Remaining material can be removed, for example, by vacuum suction and/or sucking into a porous structure. With correct selection of laser wavelengths (and solder mask lacquer), the burning process can be executed through the solder mask. Here protective after-coatings may be used to ensure proper environmental protection. Alternatively, the shorts can be burnt away by excess of electric current, for example like in the electric fuses of household devices. The current amplitude, as well as possible waveform and frequency content, needs to be optimized to ensure that the shorts are properly burnt all the way of the shorting distance, and do not leave too long conducting studs etc., that could cause issue in operation due to arcing, AC-coupling, or conductive anodic filament.

The electrochemical process can especially grow nanowire lawns for complex circuit boards with a high number of electric contacts, for example more than ten electric contacts. It can be used also for repair work of broken electronics where rejoining of components or boards to a carrier board, e.g., motherboards, is needed. As the electrochemical process takes time, the process can also be applied during transportation, for example during transportation of the circuit board between a supplier and an assembler. The electrochemical process can also be applied during intermediate storage. A sponge or film, wetted with electrolyte, may be pressed between the circuit board and the lid/cover of the transportation box, a battery may be connected between the sponge and the circuit board, and temporary electric lines can be applied as described before to contact every possible contacts. Multiple circuit boards can be treated with a sandwich-type of a structure.

The invention relates further to a circuit board fabricated using a method as described herein. With regard to the method, all disclosed embodiments and variations can be applied.

Further advantages and details may be derived from the embodiment described further below with respect to the accompanying drawing.

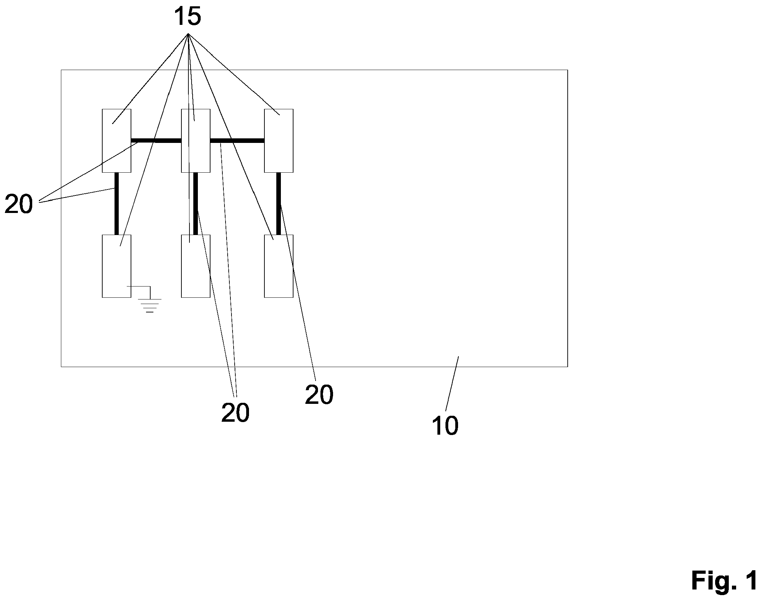

- Fig. 1:: shows a circuit board.

Fig. 1 shows a circuit board 10 according to a possible implementation. As a purely schematic illustration, several conductors 15 are provided on the circuit board 10, which are all embodied as pads. They can be used, for example, to connect an integrated circuit or capacitors in the final state of the circuit board 10.

The conductors 15 are temporarily connected by temporary electric lines 20, which connect all the conductors 15 to each other. This enables setting all the conductors 15 to the same potential, wherein in the shown state one of the conductors 15 is grounded. Thus, all conductors 15 are grounded, which can especially be beneficial during applying an electrochemical process.

After applying this electrochemical process, the temporary electric lines 20 can be removed by applying a laser beam, an ion beam, an electron beam and/or by melting them using a specific electric current. Then, the conductors 15 will be separate from each other, so that they can be used as intended.

The temporary electric lines 20 can be designed already with designing the circuit board 10, wherein it is planned that they will be removed before the circuit board 10 is brought into its final state.

Mentioned steps of the inventive method can be performed in the given order. However, they can also be performed in another order, as long as this is technically reasonable. The inventive method can, in an embodiment, for example with a certain combination of steps, be performed in such a way that no further steps are performed. However, also other steps may be performed, including steps that are not mentioned.

It is to be noted that features may be described in combination in the claims and in the description, for example in order to provide for better understandability, despite the fact that these features may be used or implemented independent from each other. The person skilled in the art will note that such features can be combined with other features or feature combinations independent from each other.

References in dependent claims may indicate preferred combinations of the respective features, but do not exclude other feature combinations.

### List of reference signs

- 10: circuit board
- 15: conductors
- 20: temporary electric lines

## Claims

1. Method for applying an electrochemical process on a plurality of conductors (15) on a circuit board (10),
the method comprising the following steps:
- fabricating the circuit board (10) such that at least some of the conductors (15) are electrically connected to each other by temporary electric lines (20), then
- applying the electrochemical process, then
- removing the temporary electric lines (20).

2. Method according to claim 1,
- wherein the removing comprises applying a laser beam, an ion beam and/or an electron beam on the temporary electric lines (20).

3. Method according to one of the preceding claims,
- wherein the removing comprises melting the temporary electric lines (20) by applying a current to the respective temporary electric lines (20).

4. Method according to one of the preceding claims,
- wherein conductors (15) electrically connected to each other are grounded, or set to a specific electric potential, before and/or during applying the electrochemical process.

5. Method according to one of the preceding claims,
- wherein the temporary electric lines (20) have a smaller width compared to the conductors (15).

6. Method according to one of the preceding claims,
- wherein the temporary electric lines (20) are made from the same material as the conductors (15).

7. Method according to one of the preceding claims,
- wherein the temporary electric lines (20) are fabricated in the same process and/or using the same steps as the conductors (15).

8. Method according to one of the preceding claims,
- wherein the circuit board (10) is fabricated such that all conductors (15) are electrically connected to each other by temporary electric lines (20).

9. Method according to one of the preceding claims,
- wherein conductors (15) are arranged on the circuit board (10) in pads and/or lines.

10. Method according to one of the preceding claims,
further comprising, after removing the temporary electric lines (20), the following step:
- depositing a passivation layer and/or protective layer on the circuit board (10), covering the conductors (15).
